# EUROPEAN PATENT APPLICATION

(11) **EP 2 696 664 A2**
(43) Date of publication of application: **12.02.2014**
(21) Application number: 13176601.6
(22) Date of filing: 16.07.2013
(51) Int. Cl.: H05K 7/14

(54) **Energy storage for power electronics device**

(30) Priority: 07.08.2012 FI 20124152 U
(71) Applicant: Vacon Oyj, 65380 Vaasa (FI)
(72) Inventor: Pouttu, Jussi, 65300 Vaasa (FI); Pakkala, Janne, 66510 Merikaarto (FI); Kinnari, Pekka, 65630 Karperö (FI); Ristimäki, Ari, 66400 Laihia (FI); Södö, Nicklas, 65280 Vaasa (FI)
(74) Representative: Järveläinen, Pertti Tauno Juhani

(57) **Abstract**

Power electronics device, more particularly a frequency converter (FC), which comprises an energy storage. The energy storage is an energy storage unit (C), which comprises at least one capacitor and a connector arrangement for the energy storage unit. The power electronics device comprises a space, in which the energy storage unit (C) can be disposed. The space comprises a connector arrangement for the space, by the aid of which the power electronics device can be electrically connected to the energy storage unit (C) via the connector arrangement for the energy storage unit. The space further comprises means for fixing the energy storage unit (C) into the space and wherein the energy storage unit (C) can be replaced in the space without changes being made in the power electronics device or in the energy storage unit (C).

## Description

### Field of technology

The present invention relates to power electronics devices.

### Prior art

In power electronics devices, which adapt electric power between two different systems, it is usually necessary to arrange temporary storage of the energy to smooth out the effects of the different timing of the instantaneous values of the powers. For example, in normal frequency converters the alternating-current electricity supplied by the electricity distribution network is rectified with a diode bridge and the waveform of direct-current voltage formed is smoothed with a high-capacitance capacitor before electronic power inversion into a second alternating-current electricity that is adjustable in its amplitude and its frequency.

It is known that the power rating, the voltage level and the dynamic performance of the device as well as the number of phases of the supplying network affect the size of the energy storage needed. For example, the contour effect of the voltage of a three-phase network that has been rectified with a diode bridge is significantly less than the waveform of a rectified single-phase network, owing to which it is known that three-phase devices need a smaller energy storage, in relation to their rated power, than single-phase devices.

In modern power electronics devices the most significant power losses arise in switch-type power semiconductor components, e.g. in IGBT transistors. Owing to this, the internal cooling ability, and via that to a large extent the structural solutions and also rated powers, are generally determined according to the power semiconductor components used.

Maximization of the power handling capability of devices generally also requires enhanced cooling of the capacitor unit functioning as an energy storage, which unit can, especially at higher powers such as over 5 kW, be composed of a number of separate capacitors. Owing to the functioning of the cooling, the location point of a unit and the connection of it in the structure of a device must generally be fixed, in which case, when using a device structure designed for a three-phase supply in a single-phase supply mode, the capacitor unit generally limits the power handling capacity of the device to lower than what would be possible insofar as the cooling of the power semiconductors is concerned. The problem is solved in prior art in such a way that devices supplied with 1-phase electricity and devices supplied with 3-phase electricity have their own separate structures, but this solution is not desirable from the viewpoint of the manufacturing process owing to the abundance of different structural elements.

### Summary of the invention

The purpose of this invention is to achieve a new type of arrangement, with which the aforementioned drawbacks are avoided and which enables the replacement of the different-sized energy storages required by different supply voltage systems and performance requirements easily in the same device frame. This aim is achieved with the arrangement according to the invention, which is characterized by what is disclosed in the characterization part of the independent claim. Other preferred embodiments of the invention are the objects of the dependent claims.

According to the invention the energy storage required by a device is configured to be a module of a specific form in terms of its outer dimensions and its connections, i.e. to be an energy storage unit, in which case in the fabrication process, or even in field conditions, it can easily be replaced for another module required by a supply system of a different power rating. The energy storage unit according to the invention can also be called a capacitor unit and it comprises at least one capacitor. The power electronics device comprises a space of corresponding size, in which the energy storage unit can be disposed. In addition, the space can comprise means for fixing the energy storage unit into the space. The space also comprises a connector system, by the aid of which the energy storage unit can, via its connector, be connected electrically to the power electronics device.

The energy storage unit according to the invention preferably also comprises the separate charging resistors and discharging resistors required by different energy storages. Also, the use of different types of capacitor in different energy storage units is possible, e.g. in such a way that so-called plastic capacitors are used in devices intended for higher three-phase supply voltage (such as 400 V), said capacitors having a low capacitance value per unit of volume but a high voltage endurance, in which case it is possible to use fewer, or even to avoid using any, serial connections of capacitors. Correspondingly, electrolytic capacitors can be used in devices intended for a lower single-phase supply voltage (such as 230 V), said capacitors having a high capacitance value per unit of volume but a low voltage endurance.

In production the arrangement according to the invention increase the possibility of performing product variation according to the so-called mass tailorization principle in as late a stage as possible, which is advantageous from the viewpoint of the flexibility and costs of the fabrication process.

### Short description of the drawings

In the following, the invention will be described in more detail by the aid some embodiments with reference to the attached drawings, wherein
Fig. 1 presents a 3-phase frequency converter,
Fig. 2 presents 1-phase rectification and filtering of the voltage,
Fig. 3 presents the waveforms relating to rectification of the supply voltage,
Figs. 4A and 4B present the circuits of different storage units,
Figs. 5A...5C present the mechanical implementation of different energy storage units,
Fig. 6 presents the placement of an energy storage unit according to the invention in a power electronics device.

### Detailed description of the invention

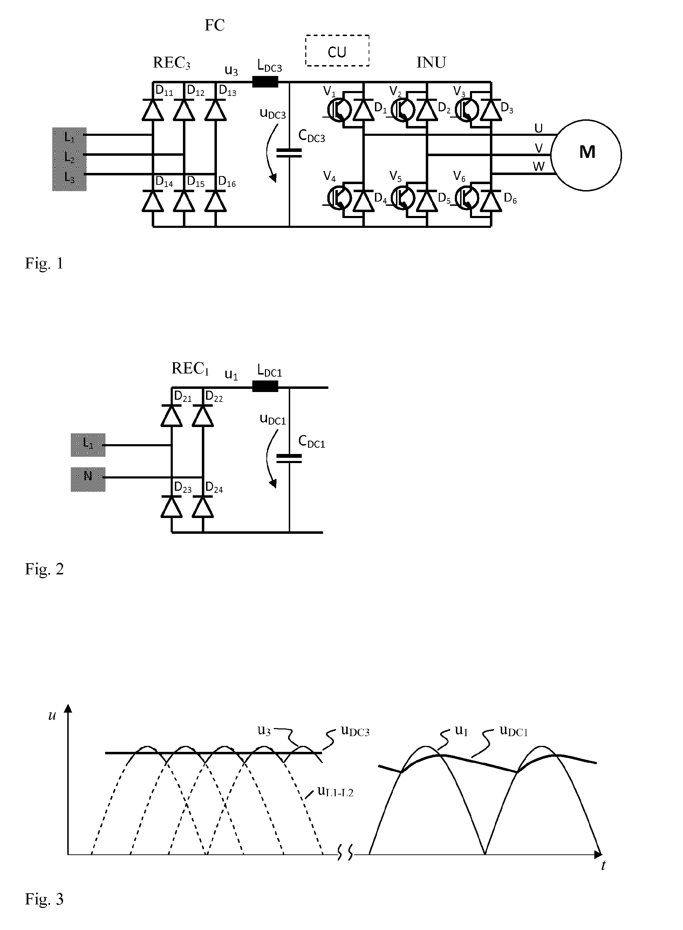

Fig. 1 presents the main circuit of a power electronics device, in this embodiment a frequency converter FC. In the device three-phase supply voltage L₁, L₂, L₃ is rectified with a so-called 6-pulse rectifier REC, which comprises in this case diodes D₁₁...D₁₆. The direct-current voltage u₃ formed is filtered with a choke L_{DC3} and with a capacitor C_{DC3} into the direct-current voltage u_{DC3} of the intermediate circuit, from which output voltage is further formed with an inverter INU, which comprises controllable power semiconductor switches, e.g. IGBTs V₁...V₆ and diodes D₁...D₆ connected in parallel with them. In the example frequency converter the output voltage poles U, V, W are normally connected to a motor M. The operation of the inverter bridge is controlled by a control unit CU.
Fig. 2 presents a rectifying arrangement in a power electronics device corresponding to the example of Fig. 1, when the supply network L₁, N is single-phase. The supply voltage is rectified with a diode bridge D₂₁...D₂₄ into direct-current voltage u₁, which is filtered with a choke L_{DC1} and with a capacitor C_{DC1} into direct-current voltage u_{DC1}, from which output voltage (not presented) is further formed correspondingly to what is in the example of Fig. 1.
Fig. 3 presents characteristic waveforms of voltages relating to single-phase rectification and three-phase rectification. The left-hand side of the figure presents the three-phase rectification according to Fig. 1, where u₃ is the unfiltered voltage after the rectifying bridge REC₃ and u_{DC3} is the almost fully smoothed voltage filtered by the choke L_{DC3} and the capacitor C_{DC3}. Correspondingly, the right-hand side of the figure presents the single-phase rectification according to Fig. 2, where u₁ is the unfiltered voltage after the rectifying bridge REC₁ and u_{DC1} is the voltage filtered by the choke L_{DC1} and the capacitor C_{DC1}. Since the contour effect of the rectified voltage u₁ is significantly greater than that of the voltage u₃, the filtering of single-phase voltage requires a significantly larger filter (a larger capacitance value of the capacitor/inductance value of the choke) than three-phase voltage.

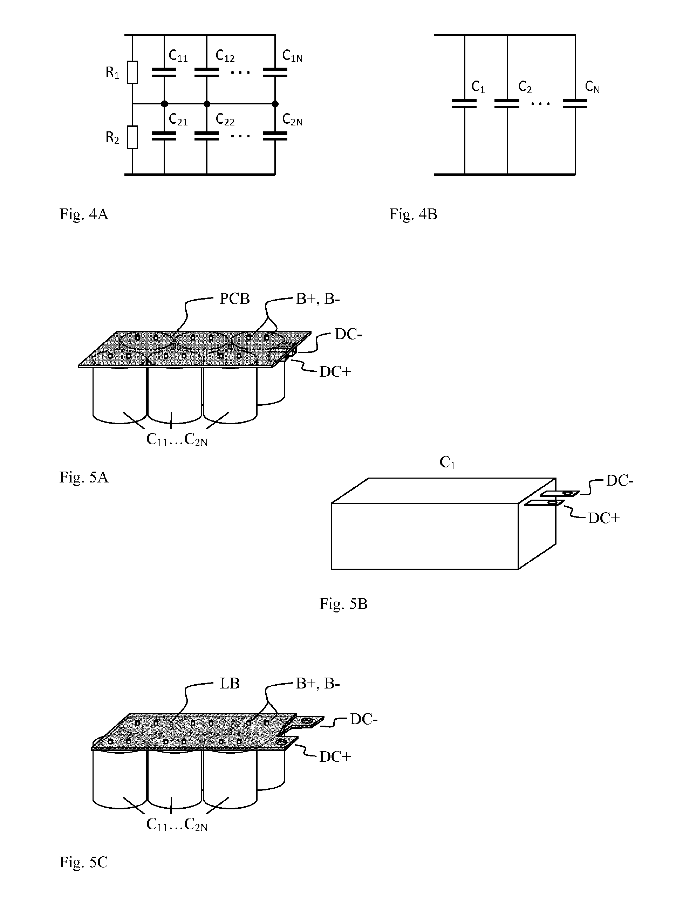

Figs. 4A and 4B show examples of different filter capacitor units. Capacitors are connected in series in the manner of Fig. 4A when the voltage level (u_{DC3}, u_{DC1}) of the whole unit is higher than the voltage endurance of an individual capacitor (C₁₁...C_{2N}), and in parallel when (C₁₁...C_{2N}, C₁...C_{N}) the load current of the whole unit is greater than the current endurance of an individual capacitor, which current endurance is generally calculated on the basis of the target lifetime. For smoothing the voltage stress of capacitors connected in series, generally resistors (R₁, R₂) are connected in parallel with them. When the voltage endurance of a capacitor is sufficiently high, serial connections are not needed but instead capacitors can be connected in parallel in the manner of Fig. 4B for achieving the necessary amount of capacitance and of current endurance.
Figs. 5A and 5B present two examples of the mechanical implementation of energy storage units composed of capacitors.

In Fig. 5A the energy storage unit is composed of can-type, e.g. snap-in capacitors C₁₁...C_{2N}, which are connected with a soldered joints (B+, B-) to the circuit board PCB connecting them, the external connectors of which circuit board are DC+ and DC-. Other components, such as voltage trimmer resistors (not presented), to be connected to the energy storage unit can also be installed on the same circuit board. In this type of construction C₁₁...C_{2N} are typically so-called electrolytic capacitors having a low voltage endurance (e.g. below 400 VDC) but a high specific capacitance value (capacitance/volume). These types of capacitors are therefore suitable for a frequency converter provided with single-phase supply voltage.

Fig.5B presents a so-called film-type power capacitor, which mechanically can be the rectangular prism shape according to the figure. The voltage endurance of a film-type capacitor is typically higher (e.g. 1000 VDC) but its specific capacitance value is smaller than with an electrolytic capacitor, so it can be sufficient for the voltage filtering needs of the intermediate circuit of a three-phase frequency converter designed for normal distribution voltage without any serial connections.

In the energy storage unit according to Fig. 5C, the capacitors C₁₁...C_{2N} are connected to busbars LB that are laminated one on top of the other, with which solution a very small internal inductance of the energy storage is achieved.

Individual capacitors can be connected to the structure connecting them with soldered joints or screw joints in the solutions in both Fig. 5A and in Fig. 5C.

In solutions according to prior art a certain fixed location in a power electronics device is arranged for an energy storage, into which only the capacitors specified for the device in question can be furnished or replaced.

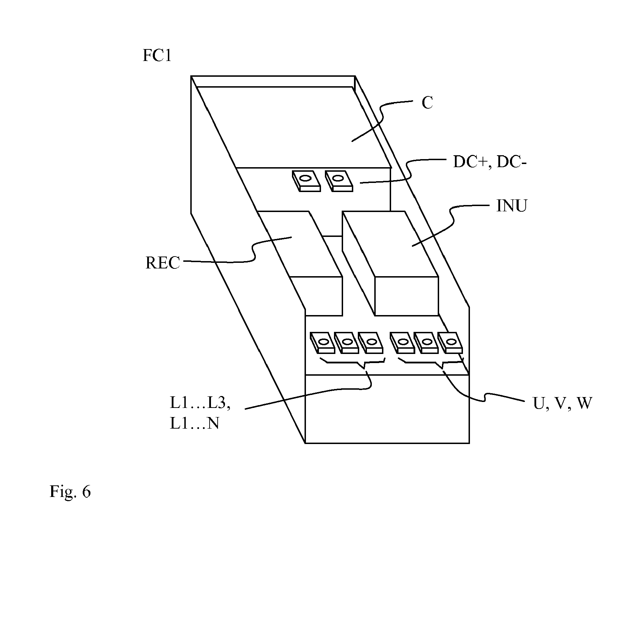

According to the present invention, the whole energy storage is arranged to be replaced, in which case also the capacitor type can be changed along with the replacement of the unit. Fig. 6 presents an example of an arrangement according to the invention, wherein an energy storage unit C is disposed inside a power electronics device FC1. When the outer dimensions of energy storages and also the connections DC+, DC- connecting to the rectifier REC and to the inverter INU remain in accordance with the location intended for the unit, different units, e.g. those illustrated by Figs. 5A...5C, can be disposed in it. In this way a mechanically similar frame of a device can easily be furnished according to the requirements of different supply voltages. For the sake of clarity, the aforementioned main components of the device and also the external connections L₁...L₃ or L₁...N as well as the wiring/busbars connecting U, V, W have been omitted from the figure.

According to one embodiment of the invention the energy storage unit can be connected electrically to a power electronics device via a connector arrangement, which connector arrangement comprises a connector arrangement for a power energy device and a connector arrangement for the energy storage unit.

It is obvious to the person skilled in the art that the different embodiments of the invention are not limited solely to the example described above, but that they may be varied within the scope of the claims presented below.

## Claims

1. Power electronics device, more particularly a frequency converter (FC), which comprises an energy storage,
**characterized in that**
the energy storage is an energy storage unit (C), which comprises at least one capacitor and a connector arrangement for the energy storage unit,
the power electronics device comprises a space, in which the energy storage unit (C) can be disposed,
the space comprises a connector arrangement for the space, by the aid of which the power electronics device can be electrically connected to the energy storage unit (C) via the connector arrangement for the energy storage unit, and
wherein the space further comprises means for fixing the energy storage unit (C) into the space and wherein the energy storage unit (C) can be replaced in the space without changes being made in the power electronics device or in the energy storage unit (C).

2. Power electronics device according to claim 1,
**characterized in that** the energy storage unit (C) comprises electrolytic capacitors, in which case the power electronics device is supplied with single-phase electricity.

3. Power electronics device according to claim 1,
**characterized in that** the energy storage unit (C) comprises plastic capacitors, in which case the power electronics device is supplied with three-phase electricity.

4. Power electronics device according to claim 1 - 3,
**characterized in that** the energy storage unit (C) comprises charging resistors and discharging resistors.
